# EUROPEAN PATENT SPECIFICATION

(11) **EP 3 725 824 B1**
(45) Date of publication and mention of the grant of the patent: **19.10.2022**
(21) Application number: 18889737.5
(22) Date of filing: 10.12.2018
(51) Int. Cl.: C08J 5/18, C08K 3/04, C08L 101/00, C09K 5/14, H01L 23/373, H05K 7/20

(54) **HEAT CONDUCTION SHEET**
WÄRMELEITFOLIE
FEUILLE THERMOCONDUCTRICE

(30) Priority: 12.12.2017 JP 2017237378
(43) Date of publication of application: 21.10.2020
(73) Proprietor: SEKISUI CHEMICAL CO., LTD., Osaka-shi Osaka 530-8565 (JP); National University Corporation Kumamoto University, Kumamoto-shi, Kumamoto 860-8555 (JP)
(72) Inventor: ASHIBA, Kouji, Mishima-gun, Osaka 618-0021 (JP); OOWASHI, Keigo, Mishima-gun, Osaka 618-0021 (JP); NOZATO, Shoji, Mishima-gun, Osaka 618-0021 (JP); TAKAFUJI, Makoto, Kumamoto-shi, Kumamoto 860-8555 (JP); IHARA, Hirotaka, Kumamoto-shi, Kumamoto 860-8555 (JP)
(74) Representative: Ter Meer Steinmeister & Partner
(86) International application number: PCT/JP2018/045250
(87) International publication number: WO 2019/117064

(56) References cited:
- WO-A1-2016/104074
- WO-A1-2016/201659
- JP-A- 2005 306 967
- JP-A- 2007 106 901
- JP-A- 2013 062 379
- JP-A- 2015 013 930
- JP-A- 2016 036 019
- US-A1- 2009 311 436
- US-A1- 2017 298 261
- "Fine and particulate higilite", SHOWA DENKO KABUSHIKI KAISHA, 25 May 2007 (2007-05-25), XP055617775, Retrieved from the Internet: URL:https://www.sdk.co.jp/assets/files/pro ducts/1203/1203_01.pdf [retrieved on 2019-02-18]

## Description

### Technical Field

The present invention relates to a heat conductive sheet having excellent heat conductivity.

### Background Art

In recent years, with the improvement in performance of electronic devices, the amount of released heat is also increased, and there are increasing demands for a heat conductive sheet having excellent heat releasability. As a conventional heat conductive sheet having excellent heat releasability, a sheet containing graphite, which is highly heat conductive, is widely known.

For example, Patent Literature 1 below discloses an expanded graphite sheet composed solely of expanded graphite. The expanded graphite sheet of Patent Literature 1 has a heat conductivity of 350 W/m·K or more in the surface direction.

Patent Literature 2 below discloses a graphite sheet laminate including a metal material sandwiched between graphite sheets. In Patent Literature 2, the graphite sheet laminate is produced by disposing a metal material between graphite sheets and performing roll milling.

Patent Literature 3 below discloses a heat conductive sheet containing expanded graphite and orientation-controlling particles. In Patent Literature 3, at least a part of the expanded graphite is oriented in a direction different from the surface direction of the sheet due to the presence of the orientation-controlling particles and, accordingly, heat conductivity in the thickness direction of the sheet is increased.

### Citation List

### Patent Literature

Patent Literature 1: Japanese Patent Laid-Open No. 2006-62922
Patent Literature 2: Japanese Patent Laid-Open No. 11-240706
Patent Literature 3: International Publication No. WO 2016/088682

### Summary of Invention

### Technical Problem

However, while the sheet of expanded graphite of Patent Literature 1 has excellent heat conductivity in the surface direction, the heat conductivity in the thickness direction is not sufficient.

In the graphite sheet laminate of Patent Literature 2, graphite is oriented in the surface direction because the graphite sheets are roll-milled in the production process. Accordingly, even when a highly heat conductive sheet is disposed between graphite sheets, the heat conductivity in the thickness direction is not sufficient.

As for the heat conductive sheet of Patent Literature 3, the heat conductivity in the thickness direction is increased but is still not sufficient.

An object of the present invention is to provide a heat conductive sheet having excellent heat conductivity in the thickness direction.

### Solution to Problem

The heat conductive sheet according to the present invention is a heat conductive sheet comprising a first carbon material having a graphene laminated structure, orientation-controlling particles, and a first resin, wherein at least a part of the first carbon material is oriented in a direction different from a surface direction of the heat conductive sheet due to the presence of the orientation-controlling particles, and a ratio of an average particle diameter of the first carbon material to an average particle diameter of the orientation-controlling particles (the first carbon material/the orientation-controlling particles) is 0.09 or more and less than 4.0.

In the heat conductive sheet according to the present invention, at least a part of the first carbon material is preferably oriented in the thickness direction of the heat conductive sheet due to the presence of the orientation-controlling particles.

In the heat conductive sheet according to the present invention, the first carbon material is preferably graphite or exfoliated graphite.

In the heat conductive sheet according to the present invention, the average particle diameter of the orientation-controlling particles is preferably 1 µm or more and 500 µm or less. More preferably, the average particle diameter of the orientation-controlling particles is 1 µm or more and 200 µm or less.

In the heat conductive sheet according to the present invention, the orientation-controlling particles are preferably composed of a second resin. More preferably, the second resin is a cross-linked resin. Even more preferably, at least a part of the surface of the second resin is coated with a second carbon material.

The heat conductive sheet according to the present invention preferably has a heat conductivity in the thickness direction of 0.8 W/(m·K) or more.

### Advantageous Effects of Invention

As described above, the heat conductive sheet according to the present invention comprises a first carbon material having a graphene laminated structure, orientation-controlling particles, and a first resin. At least a part of the first carbon material is oriented in a direction different from the surface direction of the heat conductive sheet due to the presence of the orientation-controlling particles. The ratio of the average particle diameter of the first carbon material to the average particle diameter of the orientation-controlling particles (the first carbon material/the orientation-controlling particles) is 0.09 or more and less than 4.0. Accordingly, the heat conductive sheet according to the present invention has excellent heat conductivity in the thickness direction.

### Brief Description of Drawings

[Figure 1] Figure 1 is a schematic cross-sectional view showing a heat conductive sheet according to one embodiment of the present invention.
[Figure 2] Figure 2 is an enlarged schematic cross-sectional view showing only the first carbon material of the heat conductive sheet according to one embodiment of the present invention.

### Description of Embodiments

Below, details of the present invention will now be described.

The heat conductive sheet of the present invention comprises a first carbon material, orientation-controlling particles, and a first resin. The first carbon material is a carbon material having a graphene laminated structure. At least a part of the first carbon material is oriented in a direction different from the surface direction of the heat conductive sheet due to the presence of the orientation-controlling particles. The ratio of the average particle diameter of the first carbon material to the average particle diameter of the orientation-controlling particles (the first carbon material/the orientation-controlling particles) is 0.09 or more and less than 4.0.

In the present invention, the average particle diameter can be obtained by observing a scanning electron micrograph (an SEM photograph) of the cross section of the heat conductive sheet and determining the average particle diameter of randomly selected 100 particles. When the cross-sectional shape of the particles is elliptical, the average particle diameter may be the average of the major diameters of randomly selected 100 particles.

In the heat conductive sheet of the present invention, at least a part of the first carbon material is oriented in a direction different from the surface direction of the heat conductive sheet due to the presence of the orientation-controlling particles, and the ratio of the average particle diameter of the first carbon material to the average particle diameter of the orientation-controlling particles is within the above range. Accordingly, the heat conductive sheet has excellent heat conductivity in the thickness direction.

In the present invention, when a scanning electron micrograph (an SEM photograph) of the cross-section in the thickness direction perpendicular to the surface direction of the heat conductive sheet is observed to randomly select 100 particles of the first carbon material, the average value of the angle between the length direction of the first carbon material and the surface direction of the heat conductive sheet is preferably 20° or more and more preferably 30° or more. In this case, the heat conductivity in the thickness direction of the heat conductive sheet can be further increased. The upper limit of the average value of the angle of orientation is not particularly limited and can be, for example, 90°. In this case, the entirety of the selected first carbon material is oriented in the thickness direction.

Herein, the "angle between the length direction of the first carbon material and the surface direction of the heat conductive sheet" means angle θ which will be described below.

In the present invention, at least a part of the first carbon material is preferably oriented in the thickness direction of the heat conductive sheet due to the presence of the orientation-controlling particles. In this case, the heat conductivity in the thickness direction of the heat conductive sheet can be increased further effectively. From the viewpoint of even more increasing the heat conductivity in the thickness direction of the heat conductive sheet, the entirety of the first carbon material is more preferably oriented in the thickness direction of the heat conductive sheet due to the presence of the orientation-controlling particles.

Naturally, in the present invention, at least a part of the first carbon material may be oriented in the surface direction of the heat conductive sheet. In this case, the heat conductivity in the surface direction of the heat conductive sheet can also be increased.

In the present invention, the ratio of the average particle diameter of the first carbon material to the average particle diameter of the orientation-controlling particles (the first carbon material/the orientation-controlling particles) is 0.09 or more, preferably 0.1 or more, more preferably 0.2 or more, and even more preferably 0.3 or more, and is 4.0 or less, preferably 3.5 or less, and more preferably 3.0 or less. When the ratio (the first carbon material/the orientation-controlling particles) is at the above lower limit or higher and the above upper limit or lower, the heat conductivity in the thickness direction of the heat conductive sheet can be further increased.

The heat conductivity in the thickness direction of the heat conductive sheet is not particularly limited, and is preferably 0.8 W/ (m·K) or more, more preferably 0.9 W/ (m·K) or more, even more preferably 1.0 W/ (m·K) or more, particularly preferably 1.5 W/ (m·K) or more, and most preferably 2.0 W/ (m·K) or more. When the heat conductivity in the thickness direction is at the above lower limit or higher, the heat conductivity of the heat conductive sheet can be further increased. The upper limit of the heat conductivity in the thickness direction of the heat conductive sheet is not particularly limited, and can be the heat conductivity attained when the entirety of the first carbon material is oriented in the thickness direction or less. Accordingly, the upper limit of the heat conductivity in the thickness direction of the heat conductive sheet can be, for example, 700 W/ (m·K) or less.

The heat conductivity can be determined using, for example, formula (1) below.

Heat conductivity (W/ (m·K)) = Specific gravity (g/m³) × Specific heat (J/g·K) × Thermal diffusivity (mm²/s) Formula (1)

The thermal diffusivity can be measured using, for example, product number "Laser Flash Method Thermophysical Properties Analyzer LFA-502" manufactured by Kyoto Electronics Manufacturing Co., Ltd.

The specific gravity of the heat conductive sheet is not particularly limited, and is preferably 0.9 g/cm³ or more and more preferably 1.1 g/cm³ or more, and is preferably 6.0 g/cm³ or less and more preferably 5.0 g/cm³ or less.

The thickness of the heat conductive sheet is not particularly limited, and can be, for example, 50 µm or more and 2000 µm or less.

The content ratio between the first carbon material and the orientation-controlling particles (the first carbon material:the orientation-controlling particles) is not particularly limited, and is preferably in the range of 1:0.4 to 1:4.0, and more preferably in the range of 1:0.4 to 1:2.0.

When the content ratio (the first carbon material:the orientation-controlling particles) is within the above range, a larger amount of the first carbon material can be oriented in a direction different from the surface direction of the heat conductive sheet, and the heat conductivity in the thickness direction can be further increased.

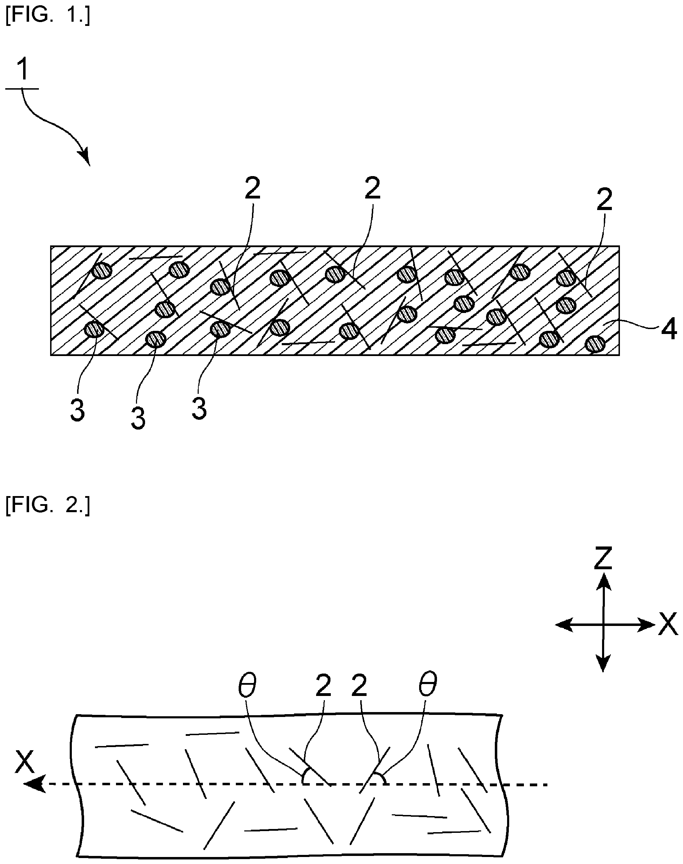

Figure 1 is a schematic cross-sectional view showing a heat conductive sheet according to one embodiment of the present invention. As shown in Figure 1, the heat conductive sheet 1 comprises a first carbon material 2, orientation-controlling particles 3, and a first resin 4. The first carbon material 2 is a carbon material having a graphene laminated structure. At least a part of the first carbon material 2 is oriented in a direction different from the surface direction of the heat conductive sheet 1 due to the presence of the orientation-controlling particles 3. The ratio of the average particle diameter of the first carbon material 2 to the average particle diameter of the orientation-controlling particles 3 (the first carbon material 2/the orientation-controlling particles 3) is 0.09 or more and less than 4.0.

In the heat conductive sheet 1, at least a part of the first carbon material 2 is oriented in a direction different from the surface direction of the heat conductive sheet 1 due to the presence of the orientation-controlling particles 3, and the ratio of the average particle diameter of the first carbon material 2 to the average particle diameter of the orientation-controlling particles 3 is within the above range. Accordingly, the heat conductive sheet 1 has excellent heat conductivity in the thickness direction.

Figure 2 is an enlarged schematic cross-sectional view showing only the first carbon material of the heat conductive sheet according to one embodiment of the present invention. The X direction in Figure 2 indicates the surface direction of the heat conductive sheet 1, and the Z direction indicates the thickness direction of the heat conductive sheet 1. The X direction and the Z direction are perpendicular to each other.

As shown in Figure 2, the above-described angle between the length direction of the first carbon material 2 and the surface direction X of the heat conductive sheet 1 can be represented by θ. That is, the angle θ is the smaller of the angles between the length direction of the first carbon material 2 and the surface direction X of the heat conductive sheet 1. In the present embodiment, the average value of this angle θ of randomly selected 100 particles of the first carbon material 2 is preferably 20° or more and more preferably 30° or more.

Below, the components of the heat conductive sheet according to the present invention, such as the heat conductive sheet 1, will now be described in more detail.

### (First carbon material)

The first carbon material is a carbon material having a graphene laminated structure. The carbon material having a graphene laminated structure may be graphite or exfoliated graphite.

Whether a carbon material has a graphene laminated structure or not can be determined by verifying whether a peak around 2θ = 26 degrees (a peak derived from a graphene laminated structure) is observed or not when an X-ray diffraction spectrum of the carbon material is measured using CuKa rays (a wavelength of 1.541 Å). The X-ray diffraction spectrum can be measured by wide angle X-ray diffractometry. For example, SmartLab (manufactured by Rigaku Corporation) can be used as an X-ray diffractometer.

The shape of the carbon material having a graphene laminated structure is not particularly limited, and may be a two-dimensionally spreading shape, a spherical shape, a fibrous shape, or an indefinite shape. The shape of the carbon material is preferably a two-dimensionally spreading shape. The two-dimensionally spreading shape may be, for example, a scale shape or a plate shape (a flat plate shape). When the carbon material has such a two-dimensionally spreading shape, the heat conductivity in the thickness direction can be further increased.

As is well known, graphite is a laminate of a plurality of graphene sheets. The number of laminated graphene sheets in graphite is about 100000 to 1000000. Natural graphite, artificial graphite, expanded graphite, or the like can be used as graphite. Expanded graphite is graphite having a larger space between graphene layers than ordinary graphite such as natural graphite and artificial graphite. Herein, graphite in which at least some spaces between graphene layers are more expanded than those in ordinary graphite is encompassed within expanded graphite.

Exfoliated graphite is obtained by subjecting original graphite to an exfoliating treatment, and refers to a graphene sheet laminate that is thinner than the original graphite. The number of laminated graphene sheets in exfoliated graphite may be smaller than that in the original graphite.

In exfoliated graphite, the number of laminated graphene sheets is preferably 2 or more and more preferably 5 or more, and is preferably 300 or less, more preferably 200 or less, and even more preferably 100 or less.

Exfoliated graphite has a shape with a large aspect ratio. Accordingly, when the first carbon material is exfoliated graphite, a reinforcing effect against external force exerted in the direction perpendicular to the laminated surface of exfoliated graphite can be effectively increased.

The aspect ratio of exfoliated graphite is preferably 20 or more, and more preferably 50 or more. The aspect ratio of exfoliated graphite is preferably 5000 or less. When the aspect ratio of exfoliated graphite is at the above lower limit or higher, the reinforcing effect against external force exerted in the direction perpendicular to the laminated surface can be further increased. When the aspect ratio of exfoliated graphite is at the above upper limit or lower, the reinforcing effect against external force exerted in the direction perpendicular to the laminated surface can be more reliably obtained. From the same viewpoints, the aspect ratio of graphite is preferably 2 or more and preferably 1000 or less.

The aspect ratio of exfoliated graphite in the present invention refers to the ratio of the maximum size in the direction of the laminated surface of exfoliated graphite to the thickness of exfoliated graphite. The aspect ratio can also be determined from the average of randomly selected 100 particles observed on a scanning electron micrograph (an SEM photograph) of the cross-section of the heat conductive sheet. In the case of graphite as well, the aspect ratio can be determined in the same manner.

Exfoliated graphite is commercially available, and can also be produced by a conventionally known method. For example, exfoliated graphite is obtained by a method such as a chemical treatment method involving intercalating ions such as nitrate ions between graphite layers and then performing a heat treatment, a physical treatment method such as applying ultrasonic waves to graphite, or an electrochemical method involving electrolysis using graphite as a working electrode.

The average particle diameter of the first carbon material is preferably 5 µm or more and more preferably 10 µm or more, and is preferably 800 µm or less, more preferably 500 µm or less, more preferably 200 µm or less, and particularly preferably 100 µm or less. In this case, the heat conductivity in the thickness direction of the heat conductive sheet can be further increased.

The shape of the first carbon material is not particularly limited, and is preferably, for example, a flake shape, a scale shape, or an elliptical shape.

The content of the first carbon material is preferably 5% by weight or more, more preferably 10% by weight or more, and even more preferably 20% by weight or more, and is preferably 90% by weight or less, more preferably 85% by weight or less, and more preferably 80% by weight or less, based on 100% by weight of the heat conductive sheet. When the content of the first carbon material is at the above lower limit or higher, the heat conductivity in the thickness direction of the heat conductive sheet can be further increased. When the content of the first carbon material is at the above upper limit or lower, the flexibility of the heat conductive sheet can be further increased.

The content of the first carbon material is preferably 50 parts by weight or more and more preferably 100 parts by weight or more, and is preferably 1000 parts by weight or less and more preferably 750 parts by weight or less, based on 100 parts by weight of the first resin. When the content of the first carbon material is at the above lower limit or higher, the heat conductivity in the thickness direction of the heat conductive sheet can be further increased. When the content of the first carbon material is at the above upper limit or lower, the flexibility of the heat conductive sheet can be further increased.

### (Orientation-controlling particles)

The orientation-controlling particles refer to particles capable of causing at least a part of the first carbon material to be oriented in a direction different from the surface direction of the sheet due to the presence thereof. The orientation-controlling particles may be an inorganic compound or an organic compound as long as the orientation-controlling particles have the above function.

In the case of an inorganic compound, for example, aluminum oxide (Al₂O₃), magnesium oxide (MgO), zirconium oxide (ZrO₂), boron nitride (BN), diamond, aluminum nitride (AlN), and spherical graphite can be used.

In the case of an organic compound, for example, a second resin can be used. In the case where the orientation-controlling particles are a second resin, resilience of a deformed second resin for resuming its original shape acts, for example, when compressive force applied by a press during the production of the heat conductive sheet is removed. Due to this resilience of the second resin, the adjacently present first carbon material can be more reliably oriented in a direction different from the surface direction. Accordingly, the heat conductivity in the thickness direction of the heat conductive sheet can be further increased.

In the case where the orientation-controlling particles are a second resin, compatibility with the first resin that serves as a matrix can be further increased, and coatability when producing the heat conductive sheet can be further increased. For example, the produced heat conductive sheet less likely has voids. Accordingly, the heat conductivity in the thickness direction of the heat conductive sheet can be further increased.

A resin that is different from the first resin can be used as the second resin. Naturally, the second resin may be a resin different from the first resin or may be the same resin. When the second resin is the same resin as the first resin, compatibility can be further increased, and coatability when producing the heat conductive sheet can be further increased. Accordingly, the heat conductivity in the thickness direction of the heat conductive sheet can be further increased.

The second resin is not particularly limited and is preferably, for example, a thermoplastic resin because it can be easily shaped while being heated. Specific examples of the thermoplastic resin include polyolefin, polystyrene, polyacrylate, polymethacrylate, polyacrylonitrile, polyester, polyamide, polyurethane, polyethersulfone, polyetherketone, polyimide, polydimethylsiloxane, polycarbonate, polyvinylidene fluoride, polytetrafluoroethylene, and a copolymer of at least two of these. One thermoplastic resin may be used singly, or a plurality of thermoplastic resins may be used in combination.

The thermoplastic resin is preferably a resin having a high compressive elastic modulus. In this case, the above-described resilience after pressing can be further increased, and the adjacently present first carbon material can be more reliably oriented in a direction different from the surface direction. Accordingly, the heat conductivity in the thickness direction of the heat conductive sheet can be further increased. Examples of such thermoplastic resins having a high compressive elastic modulus include polyolefin, polyamide, polydimethylsiloxane, polycarbonate, polyvinylidene fluoride, and polytetrafluoroethylene.

The second resin may be a cross-linked resin. When a cross-linked resin is used as the orientation-controlling particles, the first carbon material can be further reliably oriented in a direction different from the surface direction of the heat conductive sheet. Accordingly, the heat conductivity in the thickness direction of the heat conductive sheet can be further increased. Examples of the cross-linked resin include a cross-linked polystyrene resin, a cross-linked acrylic resin, and a cross-linked divinylbenzene resin.

The second resin may be coated with a second carbon material. When the orientation-controlling particles are coated with a second carbon material, compatibility with the first carbon material can be further increased, and coatability when producing the heat conductive sheet can be further increased. Accordingly, the heat conductivity in the thickness direction of the heat conductive sheet can be further increased. The second carbon material may be a carbon material different from the first carbon material, or may be the same carbon material.

For example, graphite such as natural graphite, artificial graphite or expanded graphite, exfoliated graphite, and carbon black such as acetylene black or ketjen black can be used as the second carbon material.

The average particle diameter of the orientation-controlling particles is preferably 1 µm or more and more preferably 10 µm or more, and is preferably 500 µm or less, more preferably 300 µm or less, even more preferably 200 µm or less, and particularly preferably 150 µm or less. When the average particle diameter of the orientation-controlling particles is at the above lower limit or higher, the first carbon material can be further reliably oriented in a direction different from the surface direction of the heat conductive sheet. Accordingly, the heat conductivity in the thickness direction of the heat conductive sheet can be further increased. When the average particle diameter of the orientation-controlling particles is at the above upper limit or lower, the thermal conductivity in the thickness direction of the heat conductive sheet can be further increased, and, moreover, the appearance of the heat conductive sheet can be further improved.

One type of orientation-controlling particles may be used, or a plurality of types of orientation-controlling particles having different average particle diameters and materials may be used in combination. When a plurality of types of orientation-controlling particles are used as well, the average particle diameter can be obtained by observing a scanning electron micrograph (an SEM photograph) of the cross-section of the heat conductive sheet and determining the average particle diameter of randomly selected 100 particles. When the cross-sectional shape of the particles is elliptical, the average particle diameter may be the average of the major diameters of randomly selected 100 particles.

In the present invention, two types of orientation-controlling particles having different average particle diameters are preferably used. In this case, the ratio (P/Q) between the average particle diameter P of orientation-controlling particles having a larger particle diameter and the average particle diameter Q of orientation-controlling particles having a smaller particle diameter is preferably 2.0 or more and more preferably 4.0 or more, and is preferably 15 or less and more preferably 12 or less. When the ratio (P/Q) between the average particle diameters is within the above range, the heat conductivity in the thickness direction of the heat conductive sheet can be further increased.

When determining the ratio (P/Q) of average particle diameters described above and the content ratio (R/S) described below, the "orientation-controlling particles having a larger particle diameter" means orientation-controlling particles having a particle diameter of 20 µm or more, and the "orientation-controlling particles having a smaller particle diameter" means orientation-controlling particles having a particle diameter of less than 20 µm.

The content ratio (R/S) between the content R of orientation-controlling particles having a larger particle diameter and the content S of orientation-controlling particles having a smaller particle diameter is preferably 0.2 or more, more preferably 1 or more, even more preferably 2 or more, and particularly preferably 3 or more, and is preferably 10 or less and more preferably 8 or less. In the case where the content ratio (R/S) is within the above range, the fluidity of dried matter, which will be described below, is improved when forming the dried matter into a sheet by a press, and the processability of the heat conductive sheet is further enhanced. Also, the heat conductivity in the thickness direction of the heat conductive sheet can be further increased.

The average particle diameter of the orientation-controlling particles can also be obtained by observing a scanning electron micrograph (an SEM photograph) of the cross section of the heat conductive sheet and determining the average particle diameter of randomly selected 100 particles. When the cross-sectional shape of the particles is elliptical, the average particle diameter may be the average of the major diameters of randomly selected 100 particles.

The shape of the orientation-controlling particles is not particularly limited, and is preferably, for example, spherical or crushed, and is more preferably spherical.

The average sphericity of the orientation-controlling particles is preferably 0.40 or more and more preferably 0.50 or more, and is preferably 1 or less. When the average sphericity of the orientation-controlling particles is within the above range, the heat conductivity in the thickness direction of the thermal conductive sheet can be further increased.

The average sphericity of the orientation-controlling particles can be measured as follows. First, a value represented by 4 πS/L² is determined as a sphericity, where L is the circumference of a projected image of a particle, and S is the area of the projected image of the particle. Then the sphericity, which is determined as above, of 100 particles is measured, and the average value can be regarded as the average sphericity. The average sphericity can be measured using, for example, a particle image analyzer (manufactured by Malvern, product name "Morphologi G3").

The content of the orientation-controlling particles is preferably 1% by weight or more, more preferably 5% by weight or more, and even more preferably 10% by weight or more, and is preferably 30% by weight or less and more preferably 20% by weight or less, based on 100% by weight of the heat conductive sheet.

The content of the orientation-controlling particles is preferably 30 parts by weight or more and more preferably 50 parts by weight or more, and is preferably 2000 parts by weight or less and more preferably 1500 parts by weight or less, based on 100 parts by weight of the first resin. When a plurality of types of orientation-controlling particles are used, the total content of the plurality of types of orientation-controlling particles may be within the above range. When the content of the orientation-controlling particles is at the above lower limit or higher, the heat conductivity in the thickness direction of the heat conductive sheet can be further increased. When the content of the orientation-controlling particles is at the above upper limit or lower, the flexibility of the heat conductive sheet can be further increased.

### (First resin)

The first resin is a resin used as a matrix resin. The first carbon material and the orientation-controlling particles are desirably dispersed in the first resin.

The first resin is not particularly limited, and a known thermoplastic resin can be used. Specific examples of the thermoplastic resin include polyolefin, polystyrene, polyacrylate, polymethacrylate, polyacrylonitrile, polyester, polyamide, polyurethane, polyethersulfone, polyetherketone, polyimide, polydimethylsiloxane, polycarbonate, polyvinylidene fluoride, polytetrafluoroethylene, and a copolymer of at least two of these. One thermoplastic resin may be used singly, or a plurality of thermoplastic resins may be used in combination.

Below, one exemplary production method for the heat conductive sheet will now be described in detail.

### (Production method)

In one exemplary production method, first, the first carbon material, the orientation-controlling particles, and the first resin are provided. The first resin is desirably dispersed in a solvent, and used. Naturally, the first carbon material and the orientation-controlling particles dispersed in a solvent in advance may also be used. The solvent is not particularly limited, and, for example, toluene, chloroform, N-methylpyrrolidone, THF, MEK, MIBK, dimethylacetamide, dimethyl sulfoxide, ethyl acetate, or acetone can be used.

Then, when using the first resin that is dispersed in a solvent, the first carbon material and the orientation-controlling particles are added to the dispersion and mixed. The mixing method is not particularly limited, and examples include stirring methods involving ultrasonication, a jet mill, a planetary stirrer, a disperser, a ball mill, a bead mill, a three-roll mill, a two-roll mill, a Henschel mixer, a planetary mixer, a kneader, an automatic mortar, and a melt extruder. As appropriate, mixing may be performed under heating or cooling, or may be performed under pressure or reduced pressure.

Next, the solvent of the obtained mixed solution is removed. The method for removing the solvent is preferably drying using a blowing oven or a vacuum oven because it is more convenient. The atmosphere for removing the solvent may be an air atmosphere, an inert gas atmosphere, or a vacuum. The temperature at which the solvent is removed is not particularly limited, and is preferably 10°C or higher and 100°C or lower. In the case of using the mixed solution as a film or a coating in the next pressing step, for example, the mixed solution is applied to a substrate to be formed into a film, and dried.

Next, the obtained dried matter is formed into a sheet by being pressed. At this time, the first carbon material is pressed in the presence of the orientation-controlling particles. Thus, at least a part of the first carbon material is oriented in a direction different from the surface direction of the heat conductive sheet.

Therefore, from the viewpoint of further orienting the first carbon material in a direction different from the direction of the sheet surface, preferably the first carbon material and the orientation-controlling particles are uniformly mixed in the dried matter obtained by the above method.

The method for forming a sheet by pressing is not particularly limited, and, for example, the sheet can be produced by the following method. First, the obtained dried matter is sandwiched between two flat metal plates, pressed, and left to stand for a predetermined period of time. The obtained sample may be heated for a predetermined period of time and pressed again to form a sheet. A sheet having a predetermined thickness may be obtained by repeating the above procedure to produce a plurality of sheets, stacking the sheets, and, again, pressing the stacked sheets.

The temperature during pressing is not particularly limited, and can be, for example, 30°C or higher and 400°C or lower. The pressure during pressing is also not particularly limited, and can be, for example, 1 MPa or higher and 30 MPa or lower. The pressing time is also not particularly limited, and can be, for example, 30 seconds or longer and 600 seconds or shorter.

The dried matter may be introduced into a cylinder and pressed to form a sheet. In the case of using a cylinder as well, first the dried matter is introduced into a cylinder, pressed, and left to stand for a predetermined period of time. Thereafter, the obtained sample is heated for a predetermined period of time and pressed again to form a sheet.

In the case of using a cylinder, a large amount of the dried matter can be introduced in the thickness direction, thus a sheet having a large thickness can be obtained, and a sheet having a predetermined thickness can be produced by a single operation. Thus, the first carbon material once oriented in a direction different from the plane direction is not oriented in the surface direction by being pressed again. Therefore, by pressing the dried matter using a cylinder, a heat conductive sheet in which the first carbon material is oriented in a direction different from the surface direction can be more reliably obtained.

Naturally, in the case where the orientation-controlling particles are a second resin, resilience of a deformed second resin for resuming its original shape acts, for example, when compressive force applied by a press during the production of the heat conductive sheet is removed. Due to this resilience of the second resin, the adjacently present first carbon material can be more reliably oriented in a direction different from the surface direction. Therefore, when the orientation-controlling particles are the second resin, the thermal conductivity in the thickness direction can be easily increased even without repetitive pressing or cylinder pressing as described above. Naturally, the use of a method involving repetitive pressing or cylinder pressing in combination enables the thermal conductivity in the thickness direction to be further increased.

The above production method is an example, and the present invention is not limited thereto. In the case of using a thermoplastic resin as the first resin, mixing and molding can be performed by thermal extrusion or the like without using a solvent. Also, in the case of using a thermosetting resin as the first resin, the first carbon material and the orientation-controlling particles can be dispersed in the monomer solution of the first thermosetting resin and thermally cured.

Next, the present invention will now be elucidated by way of specific Examples and Comparative Examples of the present invention. The present invention is not limited to the following Examples.

### (Example 1)

Twenty five parts by weight of graphite as a first carbon material, 55 parts by weight of cross-linked polystyrene (c-PS, manufactured by Sekisui Chemical Co., Ltd., trade name "GS-L100", average particle diameter: 100 µm) as orientation-controlling particles, and 20 parts by weight of polystyrene (PS, manufactured by Sekisui Plastics Co., Ltd., trade name "S-30") as a first resin were dispersed in toluene (manufactured by Sankyo Chemical Co., Ltd.) as a solvent. The graphite used was trade name "UP-35N" (average particle diameter: 25.4 µm) manufactured by Nippon Graphite Industries, Co., Ltd.

The obtained dispersion was stirred at 2000 rpm for 15 minutes and defoamed at 2200 rpm for 15 minutes with a planetary centrifugal mixer (manufactured by THINKY Corporation, model number "ARE-310"). Thereafter, toluene was removed with a Conveni-Evapo, and then the residue was dried with a diaphragm pump for 12 hours to obtain a mixture.

Next, the obtained mixture was placed in a hot press (manufactured by AS ONE Corporation, model number "AH-4015") and pressed at 150°C for 5 minutes by applying a pressure of 10 MPa. Thereby, a heat conductive sheet was obtained.

### (Examples 2 to 18, Comparative Examples 1 to 6)

Heat conductive sheets were obtained in the same manner as in Example 1 except that the average particle diameter of graphite, the type and the average particle diameter of orientation-controlling particles, and the amounts of graphite, orientation-controlling particles, and the first resin added were set as shown in Tables 1 to 3 below. In Examples 2, 3, 5, 12 to 18 and Comparative Example 6, cross-linked polystyrene (c-PS, manufactured by Sekisui Chemical Co., Ltd., trade name "SP-250"), average particle diameter: 50 µm) was used as orientation-controlling particles. In Example 4, cross-linked polystyrene (c-PS, manufactured by Sekisui Chemical Co., Ltd., trade name "SP-210", average particle diameter: 10 µm) was used as orientation-controlling particles. In Example 6, two types of orientation-controlling particles were used, i.e., 40 parts by weight of orientation-controlling particles (c-PS, manufactured by Sekisui Chemical Co., Ltd., trade name "SP-210", average particle diameter: 10 µm) and 10 parts by weight of orientation-controlling particles (c-PS, manufactured by Sekisui Chemical Co., Ltd., trade name "SP-250", average particle diameter: 50 µm). In Example 6, the ratio (P/Q) between the average particle diameter P of the orientation-controlling particles having a larger particle diameter and the average particle diameter Q of the orientation-controlling particles having a smaller particle diameter is 50 µm/10 µm = 5. In Example 6, the content ratio (R/S) between the content R of the orientation-controlling particles having a larger particle diameter and the content S of the orientation-controlling particles having a smaller particle diameter is 10 parts by weight/40 parts by weight = 0.25. In Example 7, cross-linked polystyrene (NG coated c-PS, manufactured by Soken Chemical & Engineering Co., Ltd., trade name "SGP-150C", average particle diameter: 50 µm) coated with graphite (trade name "UP-5NH", manufactured by Nippon Graphite Industries, Co., Ltd.) was used as orientation-controlling particles. In Example 8, cross-linked polystyrene coated with ketjen black (KB coated c-PS, manufactured by Soken Chemical & Engineering Co., Ltd., trade name "SGP-150C", average particle diameter: 50 µm) was used as orientation-controlling particles. In Example 9, aluminum oxide (Al₂O₃ manufactured by Showa Denko K.K., trade name "Alunabeads CB-P40", average particle diameter: 40 µm) was used as orientation-controlling particles. In Example 10, spherical graphite (manufactured by Nippon Graphite Industries, Co., Ltd., trade name "CBG-50", average particle diameter: 50 µm) was used as orientation-controlling particles. In Example 11, boron nitride (BN, manufactured by Momentive, trade name "PTX60", average particle diameter: 60 µm) was used as orientation-controlling particles.

As for the average particle diameter, a scanning electron micrograph (an SEM photograph) of the cross section of the heat conductive sheet was observed, and the average particle diameter of randomly selected 100 particles was determined. When the cross-sectional shape of the particles was elliptical, the average of the major diameters of randomly selected 100 particles was determined. The scanning electron microscope used was product number "S-4800" manufactured by Hitachi High-Technologies Corporation, and measurement was performed at 1000 magnifications.

The average sphericity of orientation-controlling particles was measured as follows. First, a value represented by 4 πS/L² was determined as a sphericity, where L is the circumference of a projected image of a particle, and S is the area of the projected image of the particle. Then the sphericity, which is determined as above, of 100 particles was measured, and the average value was regarded as the average sphericity. The average sphericity was measured using a particle image analyzer (manufactured by Malvern, product name "Morphologi G3").

### (Evaluation)

### Average angle:

A scanning electron micrograph (an SEM photograph) of the cross-section in the thickness direction perpendicular to the surface direction of the heat conductive sheet was observed, 100 particles of the first carbon material were randomly selected, and the average angle was determined from the average value of the angle between the length direction of the first carbon material and the surface direction of the heat conductive sheet. The scanning electron microscope used was product number "S-4800" manufactured by Hitachi High-Technologies Corporation, and measurement was performed at 1000 magnifications.

### Heat conductivity in thickness direction:

Product number "Laser Flash Method Thermophysical Properties Analyzer LFA-502" manufactured by Kyoto Electronics Manufacturing Co., Ltd. was used to determine the heat conductivity of a heat conductive sheet having 5 mm per side. The thickness of each heat conductive sheet was 1 mm.

The results are shown in Tables 1 to 3 below.

**[Table 1]**

| | | | Example 1 | Example 2 | Example 3 | Example 4 | Example 5 | Example 6 | Example 7 | Example 8 | Example 9 | Example 10 |
|---|---|---|---|---|---|---|---|---|---|---|---|---|
| First carbon material | Amount added | % by weight | 25 | 25 | 25 | 25 | 35 | 25 | 25 | 25 | 35 | 35 |
| | Average particle diameter | µm | 25.4 | 16.2 | 25.4 | 25.4 | 25.4 | 25.4 | 25.4 | 25.4 | 25.4 | 25.4 |
| Orientation-controlling particle | Composition | | c-PS | c-PS | c-PS | c-PS | c-PS | c-PS | NG coated c-PS | KB coated c-PS | Al₂O₃ | Graphite |
| | Amount added | % by weight | 55 | 55 | 55 | 55 | 50 | 40/10(50) | 70 | 70 | 50 | 50 |
| | Average particle diameter | µm | 100 | 50 | 50 | 10 | 50 | 18 | 50 | 50 | 40 | 50 |
| | Average sphericity | | 0.91 | 0.89 | 0.89 | 0.88 | 0.89 | 0.89 | 0.92 | 0.92 | 0.55 | 0.63 |
| First resin | Composition | | PS | PS | PS | PS | PS | PS | PS | PS | PS | PS |
| | Amount added | % by weight | 20 | 20 | 20 | 20 | 15 | 25 | 5 | 5 | 15 | 15 |
| Ratio of average particle diameter | First carbon material/Orientation-controlling particle | | 0.25 | 0.32 | 0.51 | 2.54 | 0.51 | 1.41 | 0.51 | 0.51 | 0.64 | 0.51 |
| Average angle | [°] | | 34 | 37 | 45 | 43 | 46 | 48 | 44 | 42 | 48 | 40 |
| Heat conductivity in thickness direction | (W/(m·K)) | | 1.10 | 1.91 | 3.60 | 1.23 | 5.83 | 2.47 | 1.26 | 3.27 | 11.76 | 18.44 |

**[Table 2]**

| | | | Example 11 | Example 12 | Example 13 | Example 14 | Example 15 | Example 16 | Example 17 | Example 18 |
|---|---|---|---|---|---|---|---|---|---|---|
| First carbon material | Amount added | % by weight | 25 | 35 | 25 | 25 | 35 | 40 | 25 | 35 |
| | Average particle diameter | µm | 25.5 | 25.4 | 25.4 | 16.2 | 16.2 | 25.4 | 4.5 | 4.5 |
| Orientation-controlling particle | Composition | | BN | c-PS | c-PS | c-PS | c-PS | c-PS | c-PS | c-PS |
| | Amount added | % by weight | 55 | 50 | 60 | 65 | 50 | 45 | 60 | 50 |
| | Average particle diameter | µm | 60 | 50 | 50 | 50 | 50 | 50 | 50 | 50 |
| | Average sphericity | | 0.62 | 0.89 | 0.89 | 0.89 | 0.89 | 0.89 | 0.89 | 0.89 |
| First resin | Composition | | PS | PS | PS | PS | PS | PS | PS | PS |
| | Amount added | % by weight | 20 | 15 | 15 | 10 | 15 | 15 | 15 | 15 |
| Ratio of average particle diameter | First carbon material/Orientation-controlling particle | | 0.425 | 0.51 | 0.51 | 0.32 | 0.32 | 0.51 | 0.09 | 0.09 |
| Average angle | [°] | | 40 | 41 | 39 | 38 | 40 | 40 | 34 | 36 |
| Heat conductivity in thickness direction | (W/(m·K)) | | 16.32 | 7.51 | 4.6 | 2.48 | 4.04 | 6.3 | 1.27 | 1.76 |

**[Table 3]**

| | | | Comparative Example 1 | Comparative Example 2 | Comparative Example 3 | Comparative Example 4 | Comparative Example 5 | Comparative Example 6 |
|---|---|---|---|---|---|---|---|---|
| First carbon material | Amount added | % by weight | 25 | 25 | 25 | 25 | 25 | - |
| | Average particle diameter | µm | 4.5 | 25.4 | 4.5 | 25.4 | 25.4 | - |
| Orientation-controlling particle | Composition | | c-PS | c-PS | c-PS | c-PS | - | c-PS |
| | Amount added | % by weight | 55 | 55 | 55 | 55 | - | 55 |
| | Average particle diameter | µm | 100 | 5 | 0.8 | 300 | - | 50 |
| | Average sphericity | | 0.91 | 0.90 | 0.89 | 0.92 | - | 0.88 |
| First resin | Composition | | PS | PS | PS | PS | PS | PS |
| | Amount added | % by weight | 20 | 20 | 20 | 20 | 75 | 45 |
| Ratio of average particle diameter | First carbon material/Orientation-controlling particle | | 0.04 | 5.08 | 5.56 | 0.08 | - | - |
| Average angle | [°] | | 19 | 22 | 23 | 23 | 15 | - |
| Heat conductivity in thickness direction | (W/(m·K)) | | 0.55 | 0.63 | 0.41 | 0.70 | 0.66 | 0.14 |

### Reference Signs List

- 1: Heat conductive sheet
- 2: First carbon material
- 3: Orientation-controlling particle
- 4: First resin

## Claims

1. A heat conductive sheet comprising a first carbon material having a graphene laminated structure, orientation-controlling particles, and a first resin, wherein
at least a part of the first carbon material is oriented in a direction different from a surface direction of the heat conductive sheet due to the presence of the orientation-controlling particles, and
a ratio of an average particle diameter of the first carbon material to an average particle diameter of the orientation-controlling particles (the first carbon material/the orientation-controlling particles), determined as explained in the description, is 0.09 or more and less than 4.0.

2. The heat conductive sheet according to claim 1, wherein at least a part of the first carbon material is oriented in a thickness direction of the heat conductive sheet due to the presence of the orientation-controlling particles.

3. The heat conductive sheet according to claim 1 or 2, wherein the first carbon material is graphite or exfoliated graphite.

4. The heat conductive sheet according to any one of claims 1 to 3, wherein an average particle diameter of the orientation-controlling particles is 1 µm or more and 200 µm or less.

5. The heat conductive sheet according to any one of claims 1 to 4, wherein the orientation-controlling particles are composed of a second resin.

6. The heat conductive sheet according to claim 5, wherein the second resin is a cross-linked resin.

7. The heat conductive sheet according to claim 5 or 6, wherein at least a part of a surface of the second resin is coated with a second carbon material.

8. The heat conductive sheet according to any one of claims 1 to 7, wherein the heat conductive sheet has a heat conductivity in a thickness direction, determined as explained in the description, of 0.8 W/ (m·K) or more.

## Patentansprüche

1. Wärmeleitfähige Folie, die ein erstes Kohlenstoffmaterial, das eine laminierte Graphen-Struktur aufweist, orientierungssteuernde Teilchen und ein erstes Harz umfasst, wobei
zumindest ein Anteil des ersten Kohlenstoffmaterials aufgrund des Vorhandenseins der orientierungssteuernden Teilchen in einer Richtung orientiert ist, die sich von einer Oberflächenrichtung der wärmeleitfähigen Folie unterscheidet, und
ein Verhältnis eines durchschnittlichen Teilchendurchmessers des ersten Kohlenstoffmaterials zu einem durchschnittlichen Teilchendurchmesser der orientierungssteuernden Teilchen (das erste Kohlenstoffmaterial/die orientierungssteuernden Teilchen), das wie in der Beschreibung erläutert bestimmt wird, 0,09 oder größer und kleiner als 4,0 ist.

2. Wärmeleitfähige Folie nach Anspruch 1, wobei zumindest ein Anteil des ersten Kohlenstoffmaterials aufgrund des Vorhandenseins der orientierungssteuernden Teilchen in einer Dickenrichtung der wärmeleitfähigen Folie orientiert ist.

3. Wärmeleitfähige Folie nach Anspruch 1 oder 2, wobei das erste Kohlenstoffmaterial Graphit oder abgeblätterter Graphit ist.

4. Wärmeleitfähige Folie nach einem der Ansprüche 1 bis 3, wobei ein durchschnittlicher Teilchendurchmesser der orientierungssteuernden Teilchen 1 µm oder größer und 200 µm oder kleiner ist.

5. Wärmeleitfähige Folie nach einem der Ansprüche 1 bis 4, wobei die orientierungssteuernden Teilchen aus einem zweiten Harz zusammengesetzt sind.

6. Wärmeleitfähige Folie nach Anspruch 5, wobei das zweite Harz ein vernetztes Harz ist.

7. Wärmeleitfähige Folie nach Anspruch 5 oder 6, wobei zumindest ein Anteil einer Oberfläche des zweiten Harzes mit einem zweiten Kohlenstoffmaterial beschichtet ist.

8. Wärmeleitfähige Folie nach einem der Ansprüche 1 bis 7, wobei die wärmeleitfähige Folie eine Wärmeleitfähigkeit in der Dickenrichtung, die wie in der Beschreibung erläutert bestimmt wird, von 0,8 W/(m · K) oder mehr aufweist.

## Revendications

1. Feuille thermoconductrice comportant une première matière carbonée ayant une structure stratifiée en graphène, des particules de commande d'orientation et une première résine, dans laquelle
au moins une partie de la première matière carbonée est orientée dans une direction différente d'une direction de surface de la feuille thermoconductrice en raison de la présence des particules de commande d'orientation, et
un rapport d'un diamètre de particule moyen de la première matière carbonée sur un diamètre de particule moyen des particules de commande d'orientation (la première matière carbonée/les particules de commande d'orientation), déterminé comme expliqué dans la description, est de 0,09 ou plus et inférieur à 4,0.

2. Feuille thermoconductrice selon la revendication 1, dans laquelle au moins une partie de la première matière carbonée est orientée dans une direction d'épaisseur de la feuille thermoconductrice en raison de la présence des particules de commande d'orientation.

3. Feuille thermoconductrice selon la revendication 1 ou 2, dans laquelle la première matière carbonée est du graphite ou du graphite exfolié.

4. Feuille thermoconductrice selon l'une quelconque des revendications 1 à 3, dans laquelle un diamètre de particule moyen des particules de commande d'orientation est de 1 µm ou plus et de 200 µm ou moins.

5. Feuille thermoconductrice selon l'une quelconque des revendications 1 à 4, dans laquelle les particules de commande d'orientation sont composées d'une seconde résine.

6. Feuille thermoconductrice selon la revendication 5, dans laquelle la seconde résine est une résine réticulée.

7. Feuille thermoconductrice selon la revendication 5 ou 6, dans laquelle au moins une partie d'une surface de la seconde résine est revêtue d'une seconde matière carbonée.

8. Feuille thermoconductrice selon l'une quelconque des revendications 1 à 7, dans laquelle la feuille thermoconductrice a une conductivité thermique dans une direction d'épaisseur, déterminée comme expliqué dans la description, de 0,8 W/(m·K) ou plus.
